# EUROPEAN PATENT APPLICATION

(11) **EP 4 793 764 A1**
(43) Date of publication of application: **19.08.2026**
(21) Application number: 24876405.2
(22) Date of filing: 26.09.2024
(51) Int. Cl.: G06F 8/654

(54) **FIRMWARE REFRESHING METHOD AND SYSTEM FOR STORAGE DEVICE, AND STORAGE MEDIUM AND STORAGE DEVICE**

(30) Priority: 09.10.2023 CN 202311303668
(71) Applicant: Rolling Wireless S.À R.L., 2540 Luxembourg (LU)
(72) Inventor: ZHU, Zhenfeng, Shenzhen, Guangdong 518055 (CN)
(74) Representative: Plasseraud IP
(86) International application number: PCT/CN2024/121392
(87) International publication number: WO 2025/077587

(57) **Abstract**

Disclosed is a firmware refresh method for a storage device, the storage device having deployed a firmware refresh mechanism. The firmware refresh method includes: performing bit flip detection on the storage device to determine a bit flip quantity when a detection time is met; and performing firmware refresh on the storage device according to the firmware refresh mechanism if the bit flip quantity reaches a critical value of redundancy detection.

## Description

### Cross-Reference to Related Applications

The present disclosure claims all the benefits of Chinese Patent Application No. 202311303668.9, filed on October 9, 2023 before the China National Intellectual Property Administration of the People's Republic of China, entitled "Firmware Refresh Method and System for Storage Device, Storage Medium, and Storage Device", which is explicitly incorporated herein by reference in its entirety.

### Field

The present disclosure generally relates to the field of data storage, particularly to a firmware refresh method and system for a storage device, a storage medium, and a storage device.

### Background

A wireless module typically includes some sub-firmware, the sub-firmware is stored on NandFlash (a non-volatile memory based on NAND technology) of the wireless module, and different regions (referred to as partitions) are divided on the NandFlash for storing different firmware. Based on physical characteristics of the NandFlash, a phenomenon of bit flip occurs in data stored on the NandFlash with extension of storage time. Reading of the stored data also causes the bit flip of the stored data. In addition, a complex electrical environment and a harsh working environment also cause the bit flip of the stored data, affecting integrity of the data stored in the NandFlash. Refreshing the firmware enables the firmware to be rewritten into the NandFlash, significantly improving stability of the data. However, excessively frequent refreshing causes a rapid decline in stability of the NandFlash. Meanwhile, once the quantity of the bit flip is excessive, the firmware is prone to irreversible damage.

### Summary

In a first aspect, the present disclosure provides a firmware refresh method for a storage device, the storage device having deployed a firmware refresh mechanism, the firmware refresh method including:
performing bit flip detection on the storage device to determine a bit flip quantity when a detection time is met; and
performing firmware refresh on the storage device according to the firmware refresh mechanism if the bit flip quantity reaches a critical value of redundancy detection.

In some embodiments, before said performing bit flip detection on the storage device to determine a bit flip quantity, the firmware refresh method further includes:
setting a timer configured to trigger the bit flip detection on the storage device to determine the bit flip quantity when the timer times out.

In some embodiments, before said setting a timer, the firmware refresh method further includes:
determining whether a current time meets the detection time; and
if the current time meets the detection time, performing bit flip detection on the storage device to determine the bit flip quantity;
if the current time does not meet the detection time, setting the timer to start countdown, and starting the timer after the countdown ends.

In some embodiments, wherein said determining whether a current time meets the detection time includes:
obtaining the current time and a historical detection time of last execution of the bit flip detection;
calculating a time difference between the current time and the historical detection time; and
confirming that the current time meets the detection time if the time difference exceeds a bit flip detection interval threshold.

In some embodiments, before said confirming that the current time meets the detection time, the firmware refresh method further includes:
determining the bit flip detection interval threshold according to an error correction algorithm type applied by the storage device.

In some embodiments, said performing bit flip detection on the storage device to determine a bit flip quantity includes:
performing hash calculation on current stored data in the storage device in units of data pages to obtain a current hash value;
determining a historical hash value of original stored data of the storage device by using redundant data in the storage device; and
determining the bit flip quantity according to the current hash value and the historical hash value.

In some embodiments, before said performing firmware refresh on the storage device, the firmware refresh method further includes:
determining the critical value according to maximum correction bits of an error correction algorithm applied by the storage device.

In another aspect, the present disclosure further provides a firmware refresh system for a storage device, the storage device having deployed a firmware refresh mechanism, the firmware refresh system including:
a bit flip detection module configured to perform bit flip detection on the storage device to determine a bit flip quantity when a detection time is met; and
a refresh detection module configured to perform firmware refresh on the storage device according to the firmware refresh mechanism if the bit flip quantity reaches a critical value of redundancy detection.

In yet another aspect, the present disclosure further provides a computer-readable storage medium on which a computer program is stored, wherein the computer program implements the firmware refresh method for a storage medium according to the present disclosure when executed by a processor.

In still another aspect, the present disclosure further provides a storage device including a memory and a processor, wherein the memory stores a computer program, and the processor implements the firmware refresh method for a storage medium according to the present disclosure when invoking the computer program stored in the memory.

In some embodiments, by detecting the bit flip quantity in the storage device and triggering the firmware refresh when the bit flip quantity meets the critical value, irregular periodic refresh is avoided, thereby effectively reducing the number of firmware refreshes of the storage device and extending the service life of the storage device, and making a time granularity of the bit flip detection smaller than a time granularity of the firmware refresh, which may discover abnormal damage to the storage device as early as possible and ensure integrity and stability of the storage device.

### Brief Description of the Drawings

In order to more clearly describe the technical solutions of the embodiments of the present disclosure, the accompanying drawings that need to be used in the embodiments are briefly described below. Obviously, the accompanying drawings to be described below merely illustrate the embodiments of the present disclosure, and it should be understood that for those of ordinary skill in the art, other drawings can be obtained according to the provided drawings without inventive work.
FIG. 1 is a flowchart of a firmware refresh method for a storage device provided by an embodiment of the present disclosure;
FIG. 2 is a structural diagram of a firmware refresh system for a storage device provided by an embodiment of the present disclosure; and
FIG. 3 is a structural diagram of a storage device provided by an embodiment of the present disclosure.

### Detailed Description

In order to make objects, technical solutions, and advantages of embodiments of the disclosure clearer, the technical solutions in the embodiments of the disclosure will be clearly and fully described in combination with the accompanying drawings in the embodiments of the present disclosure. Obviously, the embodiments to be described are part of embodiments but not all embodiments of the disclosure. Based on the embodiments of the disclosure, all other embodiments obtained by those of ordinary skill in the art without inventive work shall fall within the scope of the disclosure.

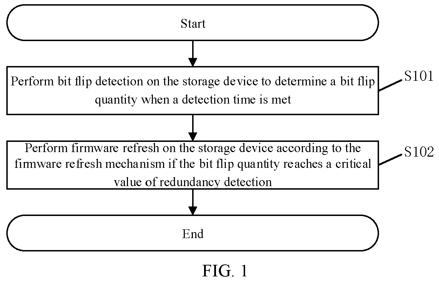

Referring to FIG. 1, FIG. 1 is a flowchart of a firmware refresh method for a storage device provided by an embodiment of the present disclosure, and the method includes:
S101: performing bit flip detection on the storage device to determine a bit flip quantity when a detection time is met; and
S102: performing firmware refresh on the storage device according to a refresh mechanism of the firmware if the bit flip quantity reaches a critical value of redundancy detection.

In some embodiments, the bit flip detection is performed on the storage device when the detection time is met to determine the bit flip quantity in the storage device. Herein, a setting method of the detection time is not limited, and the detection time for performing the bit flip detection may be determined by setting a timer. A timer may be set before performing the bit flip detection on the storage device to determine the bit flip quantity. Thus, when the timer times out, the step of performing the bit flip detection on the storage device to determine the bit flip quantity may be triggered. It should be noted that the timer is configured to trigger the bit flip detection after timing, avoiding a new bit flip during detection.

In some embodiments, whether a current time meets the detection time may be determined when the timer is set; if the current time meets the detection time, the step of performing the bit flip detection on the storage device to determine the bit flip quantity may be directly executed. Otherwise, the timer is set to start countdown, and the timer is started after the countdown ends. Herein, how to determine whether the current time meets the detection time is not limited. In some embodiments, a maximum detection time cycle may be further set by setting a detection cycle, a detection time window, or the like. In some embodiments, setting the maximum detection time cycle may ensure periodic bit flip detection of the storage device, which may be executed according to the following steps:
obtaining the current time and a historical detection time of last execution of the bit flip detection;
calculating a time difference between the current time and the historical detection time; and
confirming that the current time meets the detection time if the time difference exceeds a bit flip detection interval threshold.

The current time is obtained first, and the historical detection time of the last execution of the bit flip detection is determined. If the historical detection time of the bit flip detection is not inquired, it indicates that the storage device has not executed the bit flip detection, and the current time may be considered to meet the detection time.

After the historical detection time is obtained, the time difference between the current time and the historical detection time is further determined. If the time difference has exceeded the bit flip detection interval threshold, the current time may also be directly confirmed to meet the detection time. Certainly, this process defaults on requiring the bit flip detection interval threshold to be determined in advance. Herein, how to determine the bit flip detection interval threshold is not specifically limited. In a feasible manner, the bit flip detection interval threshold may be determined according to an error correction algorithm type applied by the storage device. Since different error correction algorithm types have different data correction capabilities, for example, some error correction algorithms may correct 8-bit data, and some error correction algorithms may correct 16-bit data, the error correction algorithm type with more correctable bits may correspondingly set longer bit flip detection interval threshold. By setting the bit flip detection interval threshold adapted to the error correction algorithm type, frequent execution of the firmware refresh may be avoided. Since the firmware refresh requires reading and writing to the storage device, and a higher firmware refresh frequency leads to a lower service life of the storage device, setting the bit flip detection interval threshold adapted to the error correction algorithm type may effectively extend the service life of the storage device.

The hash algorithm is mainly used when performing the bit flip detection on the storage device to determine the bit flip quantity, and the bit flip quantity is determined by means of redundant data. In some embodiments, the process may be as follows:
performing hash calculation on current stored data in the storage device in units of data pages to obtain a current hash value;
determining a historical hash value of original stored data of the storage device by using the redundant data in the storage device; and
determining the bit flip quantity according to the current hash value and the historical hash value.

Since the stored data in the storage device is usually stored in units of data pages, the hash calculation may be performed in units of data pages to obtain the current hash value when the bit flip quantity is determined. Thereafter, the historical hash value of the original stored data may be determined by using the redundant data of the error correction algorithm, and then the bit flip quantity is determined according to the current hash value and the historical hash value.

In addition, the critical value may be determined according to maximum correction bits of the error correction algorithm applied by the storage device before performing the firmware refresh on the storage device. It should be noted that the critical value is usually less than the maximum correction bits to avoid a new bit flip during execution of the bit flip detection. For example, if the maximum correction bits are 16 bits, the critical value may be 12 bits.

In some embodiments, by detecting the bit flip quantity in the storage device and triggering the firmware refresh when the bit flip quantity meets the critical value, irregular periodic refresh is avoided, thereby effectively reducing the number of firmware refreshes of the storage device and extending the service life of the storage device, and making a time granularity of the bit flip detection smaller than a time granularity of the firmware refresh, which may discover abnormal damage to the storage device as early as possible and ensure integrity and stability of the storage device.

The firmware refresh method for the storage device provided by the present disclosure is described below by taking a wireless module as an example, the wireless module having deployed the firmware refresh mechanism described in the background:
after startup of the wireless module is completed, checking a historical detection time of the last bit flip detection and a system current time, and calculating a time difference between the current time and the historical detection time;
if the time difference exceeds the bit flip detection interval threshold for executing the bit flip detection, setting a timer (for example, setting to a 5-second countdown) to trigger the bit flip detection, and entering a fourth step to wait for timeout of the timer;
if the time difference does not exceed the bit flip detection interval threshold for executing the bit flip detection, which indicates that the bit flip detection interval threshold is not exceeded from the current time to the historical detection time of the last bit flip detection, starting countdown of the timer and counting down the remaining time of the timer, and entering a fourth step to wait for timeout of the timer;
after the countdown of the timer ends, triggering the bit flip detection and saving time information of the bit flip detection;
counting the bit flip quantity determined by the current bit flip detection, and if the number of bits of bit flip detection exceeds the critical value of the redundancy detection, performing the firmware refresh on the storage device according to the firmware refresh mechanism; and
ending the current detection, and entering a next detection process.

A firmware refresh system for a storage device provided by the embodiments of the disclosure will be described below, and the firmware refresh system for a storage device to be described below and the firmware refresh method for a storage device described above refer to each other.

The present disclosure further provides a firmware refresh system for a storage device, the storage device having deployed a firmware refresh mechanism, the firmware refresh system including:
a bit flip detection module configured to perform bit flip detection on the storage device to determine a bit flip quantity when a detection time is met; and
a refresh detection module configured to perform firmware refresh on the storage device according to the firmware refresh mechanism if the bit flip quantity reaches a critical value of redundancy detection.

In some embodiments, the firmware refresh system further includes:
a timer setting module configured to set a timer configured to trigger the bit flip detection on the storage device to determine the bit flip quantity when the timer times out.

In some embodiments, the firmware refresh system further includes:
a detection time determining module configured to determine whether a current time meets the detection time; and if the current time meets the detection time, entering the bit flip detection module; if the current time does not meet the detection time, setting the timer to start countdown, and starting the timer after the countdown ends.

In some embodiments, the detection time determining module includes:
a time obtaining unit configured to obtain the current time and a historical detection time of last execution of the bit flip detection;
a time difference calculating unit configured to calculate a time difference between the current time and the historical detection time; and
a time determining unit configured to confirm that the current time meets the detection time if the time difference exceeds a bit flip detection interval threshold.

In some embodiments, the firmware refresh system further includes:
a threshold setting unit configured to determine the bit flip detection interval threshold according to an error correction algorithm type applied by the storage device.

In some embodiments, the bit flip detection module includes:
a first hash calculation unit configured to perform hash calculation on current stored data in the storage device in units of data pages to obtain a current hash value;
a second hash calculation unit configured to determine a historical hash value of original stored data of the storage device by using redundant data in the storage device; and
a bit flip calculation unit configured to determine the bit flip quantity according to the current hash value and the historical hash value.

In some embodiments, the firmware refresh system further includes:
a critical value determining module configured to determine the critical value according to maximum correction bits of an error correction algorithm applied by the storage device.

The present disclosure further provides a computer-readable storage medium on which a computer program is stored. The computer program implements the firmware refresh method for a storage medium according to the present disclosure when executed by a processor. In some embodiments, the storage medium may include various media capable of storing program codes such as a USB flash disk, a mobile hard disk, a read-only memory (ROM), a random access memory (RAM), a magnetic disk and an optical disk.

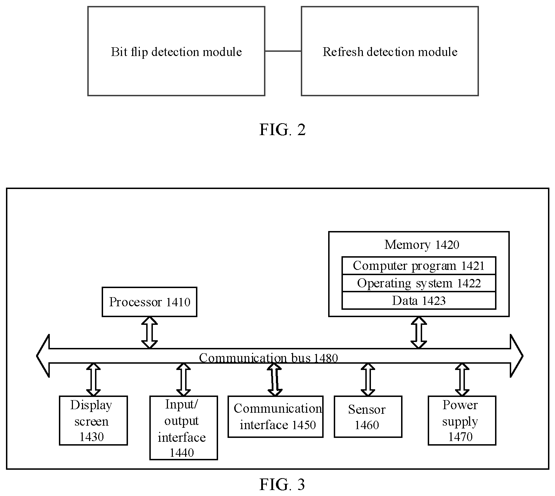

The present disclosure further provides a storage device. Referring to FIG. 3, FIG. 3 is a structural diagram of the storage device provided by an embodiment of the present disclosure. As shown in FIG. 3, the storage device may include a processor 1410 and a memory 1420.

In some embodiments, the processor 1410 may include one or more processing cores, such as a 4-core processor or an 8-core processor. The processor may be implemented in at least one hardware form of digital signal processing (DSP), a field programmable gate array (FPGA), and a programmable logic array (PLA). In some embodiments, the processor 1410 may also include a main processor and a coprocessor. The main processor is a processor configured to process data in the wakeup state, also referred to as a central processing unit (CPU); a coprocessor is a low-power consumption processor configured to process data in the standby state. In some embodiments, the processor 1410 may be integrated with a graphics processing unit (GPU) which is configured to render and draw content that needs to be displayed on the display. In some embodiments, the processor 1410 may also include an artificial intelligence (AI) processor which is configured to process computation related to machine learning.

In some embodiments, the memory 1420 may include one or more computer-readable storage media which may be non-transient. The memory 1420 may also include a high-speed random access memory and a non-volatile memory, such as one or more disk storage devices or flash storage devices. In some embodiments, the memory 1420 is at least configured to store a following computer program 1421. The computer program is capable of implementing the firmware refresh method for the storage device described in the present disclosure after being loaded and executed by the processor 1410. In some embodiments, resources stored in the memory 1420 may further include an operating system 1422, data 1423, and the like, and a storage manner thereof may be temporary storage or permanent storage. Specifically, the operating system 1422 may include Windows, Linux, Android, and the like.

In some embodiments, the storage device may further include a display screen 1430, an input/output interface 1440, a communication interface 1450, a sensor 1460, a power supply 1470, and a communication bus 1480.

Of course, the structure of the storage device shown in FIG. 3 does not constitute a limitation on the storage device in the embodiments of the disclosure. In practical applications, the storage device may include more or fewer components than those shown in FIG. 3, or combine some of the components.

The embodiments in the description are described in a progressive manner. Each embodiment focuses on a difference from other embodiments, and reference may be made to the same or similar parts between the embodiments. Since the system provided in the embodiment corresponds to the method provided in the embodiment, description thereof is relatively simple, and the related parts can refer to description of the method.

The principle and implementation of the present disclosure are described herein using specific examples, and description of the above embodiments is only intended to help understand the method of the present disclosure and the core idea thereof. It should be noted that, a person skilled in the art may make improvements and modifications to the present disclosure without departing from the principle of the present disclosure, and these improvements and modifications shall fall within the scope of the claims of the present disclosure.

It should be noted that relationship terms such as "first" and "second" herein are used solely to distinguish one entity or operation from another entity or operation without necessarily requiring or implying any actual relationship or order between the entities or operations. Furthermore, the terms "comprise", "comprising", or any other variants thereof are intended to encompass a non-exclusive inclusion, such that a process, method, article, or device that comprises a series of elements does not only comprise those elements but comprises other elements not expressly listed or elements inherent to such a process, method, article, or device. Without more limitations, an element defined by a phrase "comprise a..." does not exclude the presence of additional identical elements in the process, method, article, or device that comprises the elements.

## Claims

1. A firmware refresh method for a storage device, the storage device having deployed a firmware refresh mechanism, the firmware refresh method comprising:
performing bit flip detection on the storage device to determine a bit flip quantity when a detection time is met; and
performing firmware refresh on the storage device according to the firmware refresh mechanism if the bit flip quantity reaches a critical value of redundancy detection.

2. The firmware refresh method according to claim 1, before said performing bit flip detection on the storage device to determine a bit flip quantity, further comprising:
setting a timer configured to trigger the bit flip detection on the storage device to determine the bit flip quantity when the timer times out.

3. The firmware refresh method according to claim 2, before said setting a timer, further comprising:
determining whether a current time meets the detection time; and
if the current time meets the detection time, performing bit flip detection on the storage device to determine the bit flip quantity;
if the current time does not meet the detection time, setting the timer to start countdown, and starting the timer after the countdown ends.

4. The firmware refresh method according to claim 3, wherein said determining whether a current time meets the detection time comprises:
obtaining the current time and a historical detection time of last execution of the bit flip detection;
calculating a time difference between the current time and the historical detection time; and
confirming that the current time meets the detection time if the time difference exceeds a bit flip detection interval threshold.

5. The firmware refresh method according to claim 4, before said confirming that the current time meets the detection time, further comprising:
determining the bit flip detection interval threshold according to an error correction algorithm type applied by the storage device.

6. The firmware refresh method according to any one of claims 1 to 5, wherein said performing bit flip detection on the storage device to determine a bit flip quantity comprises:
performing hash calculation on current stored data in the storage device in units of data pages to obtain a current hash value;
determining a historical hash value of original stored data of the storage device by using redundant data in the storage device; and
determining the bit flip quantity according to the current hash value and the historical hash value.

7. The firmware refresh method according to any one of claims 1 to 6, before said performing firmware refresh on the storage device, further comprising:
determining the critical value according to maximum correction bits of an error correction algorithm applied by the storage device.

8. A firmware refresh system for a storage device, the storage device having deployed a firmware refresh mechanism, the firmware refresh system comprising:
a bit flip detection module configured to perform bit flip detection on the storage device to determine a bit flip quantity when a detection time is met; and
a refresh detection module configured to perform firmware refresh on the storage device according to the firmware refresh mechanism if the bit flip quantity reaches a critical value of redundancy detection.

9. A computer-readable storage medium on which a computer program is stored, wherein the computer program implements the firmware refresh method for a storage medium according to any one of claims 1 to 7 when executed by a processor.

10. A storage device comprising a memory and a processor, wherein the memory stores a computer program, and the processor implements the firmware refresh method for a storage medium according to any one of claims 1 to 7 when invoking the computer program stored in the memory.
